# EUROPEAN PATENT APPLICATION

(11) **EP 4 841 891 A1**
(43) Date of publication of application: **18.11.2026**
(21) Application number: 24923513.6
(22) Date of filing: 10.12.2024
(51) Int. Cl.: H03F 3/21, H03F 3/19, H03F 1/02, H03F 1/56, H04B 1/40, H04W 88/08

(54) **POWER AMPLIFIER, RADIO FREQUENCY CHIP AND BASE STATION**

(30) Priority: 05.02.2024 CN 202410172043
(71) Applicant: Huawei Technologies Co., Ltd., Shenzhen, Guangdong 518129 (CN)
(72) Inventor: YANG, Chaowei, Shenzhen, Guangdong 518129 (CN); ZHONG, Qilin, Shenzhen, Guangdong 518129 (CN); LUO, Bangyu, Shenzhen, Guangdong 518129 (CN); ZHOU, Qiang, Shenzhen, Guangdong 518129 (CN); LUO, Yang, Shenzhen, Guangdong 518129 (CN)
(74) Representative: Gill Jennings & Every LLP
(86) International application number: PCT/CN2024/138192
(87) International publication number: WO 2025/167311

(57) **Abstract**

This application provides a power amplifier, a radio frequency chip, and a base station, and relates to the field of power amplifier technologies, to mitigate the issue of increased circuit complexity of power amplifiers. The power amplifier includes: a carrier amplifier, a first peaking amplifier, and a second peaking amplifier, where a first impedance inverter circuit is disposed between an output end of the carrier amplifier and an output end of the first peaking amplifier, a second impedance inverter circuit is disposed between the output end of the first peaking amplifier and an output end of the second peaking amplifier, and the first impedance inverter circuit and the second impedance inverter circuit have opposite phases and a same phase compensation angle.

## Description

This application claims priority to Chinese Patent Application No. 202410172043.1, filed with the China National Intellectual Property Administration on February 5, 2024 and entitled "POWER AMPLIFIER, RADIO FREQUENCY CHIP, AND BASE STATION", which is incorporated herein by reference in its entirety.

### TECHNICAL FIELD

Embodiments of this application relate to the field of power amplifier technologies, and in particular, to a power amplifier, a radio frequency chip, and a base station.

### BACKGROUND

In modern wireless communication systems, power amplifiers (power amplifiers, PAs) play an important role. They amplify low-power signals from modulators into high-power signals that are capable of driving antennas for long-distance transmission. The power amplifiers are required to exhibit high efficiency, linearity, and broadband characteristics to ensure effective signal transmission and high communication quality.

Currently, structures of the power amplifiers are evolving towards multi-way structures, which in turn increases circuit complexity.

### SUMMARY

Embodiments of this application provide a power amplifier, a radio frequency chip, and a base station, to mitigate the issue of increased circuit complexity in power amplifiers.

To achieve the foregoing objective, the following technical solutions are used in embodiments of this application.

According to a first aspect, this application provides a power amplifier, including a carrier amplifier, a first peaking amplifier, and a second peaking amplifier, where a first impedance inverter circuit is disposed between an output end of the carrier amplifier and an output end of the first peaking amplifier, a second impedance inverter circuit is disposed between the output end of the first peaking amplifier and an output end of the second peaking amplifier, and the first impedance inverter circuit and the second impedance inverter circuit have opposite phases and a same phase compensation angle.

According to the power amplifier provided in this application, the first impedance inverter circuit and the second impedance inverter circuit that have the opposite phases but the same phase compensation angle are disposed between the carrier amplifier, the first peaking amplifier, and the second peaking amplifier, so that phases of signals at a combination point may be consistent, and no additional phase compensation circuit needs to be added at an input end of the second peaking amplifier. While achieving a same effect, a quantity of phase compensation circuits is reduced compared with a conventional power amplifier, and a circuit area of the power amplifier is further reduced. In addition, because a quantity of components in the power amplifier is reduced, reliability and stability of a system are improved.

In a possible implementation, the power amplifier further includes a phase compensation circuit, where the phase compensation circuit is connected to an input end of the first peaking amplifier, and the phase compensation circuit and the second impedance inverter circuit have opposite phases and a same phase compensation angle.

According to the power amplifier provided in this application, to ensure that the phases of the signals at the combination point are consistent, the phase compensation circuit whose phase is opposite to that of the second impedance inverter circuit and whose phase compensation angle is the same as that of the second impedance inverter circuit may be disposed at the input end of the first peaking amplifier. Ensuring that the phases of the signals at the combination point are consistent can ensure that phases of different signals are synchronized during combination, and prevent interference or distortion caused by phase differences. Phase consistency is implemented by the phase compensation circuit. In this way, not only performance and the stability of the system can be improved, but also energy waste can be effectively reduced, so that the power amplifier can work in a more efficient manner, thereby better meeting an actual application requirement.

In a possible implementation, the power amplifier further includes a third peaking amplifier, and a third impedance inverter circuit is disposed between an output end of the third peaking amplifier and the output end of the second peaking amplifier.

In a possible implementation, the power amplifier further includes a plurality of third peaking amplifiers, a third impedance inverter circuit is disposed between an output end of one of the third peaking amplifiers and the output end of the second peaking amplifier, and the third impedance inverter circuit is disposed between output ends of any two cascaded third peaking amplifiers.

In a possible implementation, at least two adjacent third impedance inverter circuits have opposite phases and a same phase compensation angle.

In a possible implementation, any two adjacent third impedance inverter circuits have a same phase and a same phase compensation angle.

In a possible implementation, the first impedance inverter circuit is a high-pass circuit, and the second impedance inverter circuit is a low-pass circuit.

According to the power amplifier provided in this application, the first impedance inverter circuit is the high-pass circuit. The high-pass circuit has a good suppression effect on a low-frequency signal, which helps improve broadband linearity, and different drain voltage supply can be applied to the carrier amplifier and the first peaking amplifier. In addition, the peaking amplifier allows higher drain voltage supply, and may provide higher output power during a signal peak period. Therefore, a better broadband characteristic may be obtained when a high-frequency signal is processed.

In a possible implementation, the high-pass circuit includes: a first inductor, a second inductor, and a first capacitor, where a first end of the first inductor and a first end of the first capacitor are connected to an input end of the high-pass circuit, a first end of the second inductor and a second end of the first capacitor are connected to an output end of the high-pass circuit, and a second end of the first inductor and a second end of the second inductor are connected to a ground end.

In a possible implementation, the low-pass circuit includes: a second capacitor, a third capacitor, and a third inductor, where a first end of the second capacitor and a first end of the third inductor are connected to an input end of the low-pass circuit, a first end of the third capacitor and a second end of the third inductor are connected to an output end of the low-pass circuit, and a second end of the second capacitor and a second end of the third capacitor are connected to a ground end.

According to a second aspect, this application provides a radio frequency chip, including a substrate and a power amplifier, where the power amplifier is disposed on the substrate, and the power amplifier is the power amplifier according to the first aspect.

According to a third aspect, this application provides a base station, including a baseband processing circuit and a radio frequency front-end circuit, where the baseband processing circuit is connected to the radio frequency front-end circuit, the radio frequency front-end circuit includes a power amplifier, and the power amplifier is the power amplifier according to the first aspect.

For technical effects of the second aspect and the third aspect, refer to technical effects of the first aspect and any implementation of the first aspect. Details are not described herein again.

### BRIEF DESCRIPTION OF DRAWINGS

FIG. 1 is a schematic of a structure of a radio frequency front-end circuit according to an embodiment of this application;
FIG. 2 is a power-efficiency matching curve diagram of a power amplifier according to an embodiment of this application;
FIG. 3 is a schematic of a structure of a power amplifier according to an embodiment of this application;
FIG. 4 is a circuit diagram of an impedance inverter circuit according to an embodiment of this application;
FIG. 5 is a circuit diagram of another impedance inverter circuit according to an embodiment of this application;
FIG. 6 is a circuit diagram of another impedance inverter circuit according to an embodiment of this application;
FIG. 7 is a schematic of another structure of a power amplifier according to an embodiment of this application;
FIG. 8 is a circuit diagram of another impedance inverter circuit according to an embodiment of this application;
FIG. 9a to FIG. 9c are circuit diagrams of another impedance inverter circuit according to an embodiment of this application;
FIG. 10 is a power-efficiency matching curve diagram of another power amplifier according to an embodiment of this application;
FIG. 11 is a schematic of another structure of a power amplifier according to an embodiment of this application;
FIG. 12 is a circuit diagram of another impedance inverter circuit according to an embodiment of this application;
FIG. 13 is a schematic of another structure of a power amplifier according to an embodiment of this application; and
FIG. 14 is a circuit diagram of another impedance inverter circuit according to an embodiment of this application.

### DESCRIPTION OF EMBODIMENTS

Terms used in the following embodiments are merely intended to describe specific embodiments, but are not intended to limit this application. The terms "one", "a", "the foregoing", "the", and "this" of singular forms used in this specification and the appended claims of this application are also intended to include a form such as "one or more", unless otherwise specified in the context clearly. It should be further understood that, in the following embodiments of this application, "at least one" and "one or more" mean one or more (including two). The character "/" generally indicates an "or" relationship between the associated objects.

The following describes the technical solutions in embodiments of this application with reference to the accompanying drawings in embodiments of this application. It is clear that the described embodiments are merely a part rather than all of embodiments of this application.

The terms such as "first" and "second", below are merely for convenience of description, and are not to be construed as indicating or implying relative importance or implicitly indicating a quantity of indicated technical features. Therefore, a feature limited by "first", "second", or the like may explicitly or implicitly include one or more features. In the descriptions of this application, unless otherwise stated, "a plurality of" means two or more than two. For example, a plurality of processing units means two or more processing units.

In addition, in embodiments of this application, "up", "down", "left", and "right" are not limited to definitions relative to directions in which components are schematically placed in the accompanying drawings. It should be understood that these directional terms may be relative concepts used for relative description and clarification, and may change correspondingly based on a change of a direction in which a component in the accompanying drawings is placed. In the accompanying drawings, for clarity, thicknesses of layers and regions are exaggerated, and a size proportion relationship between portions in the figures does not reflect an actual size proportion relationship.

In embodiments of this application, unless otherwise explicitly specified and limited, the term "connection" should be understood in a broad sense. For example, the "connection" may be a fixed connection, a detachable connection, or an integrated connection. Alternatively, the "connection" may be a direct connection or an indirect connection through an intermediary. Further, the term "electrical connection" may be a direct electrical connection or an indirect electrical connection through an intermediary.

In embodiments of this application, the term "module" is usually a functional structure divided based on logic, and the "module" may be implemented by pure hardware, or may be implemented by a combination of software and hardware. In embodiments of this application, the term "and/or" describes an association relationship between associated objects and indicates that three relationships may exist. For example, A and/or B may indicate the following three cases: Only A exists, only B exists, and both A and B exist.

In embodiments of this application, terms such as "example" or "for example" are used to represent giving an example, an illustration, or a description. Any embodiment or design scheme described as an "example" or "for example" in embodiments of this application should not be explained as being more preferred or having more advantages than another embodiment or design scheme. Exactly, use of the terms such as "example" or "for example" is intended to present a relative concept in a specific manner.

The technical solutions of this application may be applied to various communication devices including a power amplifier. The communication device may be deployed on land, including an indoor or outdoor device, or a handheld or vehicle-mounted device, or may be deployed on water (for example, on a ship); or may be deployed in the air (for example, on an airplane, a balloon, or a satellite). For example, the communication device may be a base station, and the base station includes a baseband processing circuit and a radio frequency front-end circuit.

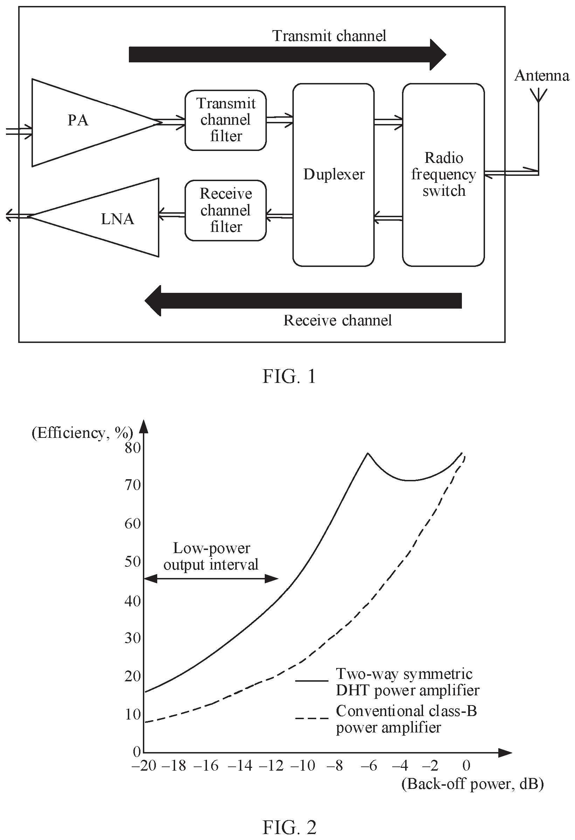

FIG. 1 is a schematic of a structure of a radio frequency front-end circuit according to an embodiment of this application.

Usually, the radio frequency front-end circuit includes but is not limited to a radio frequency switch, a duplexer, a filter, a power amplifier (power amplifier, PA), a low noise amplifier circuit (low noise amplifier, LNA), and the like. For example, as shown in FIG. 1, the radio frequency front-end circuit may include a radio frequency switch, a duplexer, a filter, a power amplifier, and a low noise amplifier.

The radio frequency front-end circuit may include a transmit channel and a receive channel. The transmit channel includes the power amplifier and a transmit channel filter, and a radio frequency output end of the power amplifier is coupled to an input end of the transmit channel filter. The receive channel includes the low noise amplifier and a receive channel filter, and an output end of the receive channel filter is coupled to a radio frequency input end of the low noise amplifier.

The duplexer is responsible for performing duplex switching in a frequency division duplex system and filtering a radio frequency signal of the receive channel/transmit channel, and the radio frequency switch is responsible for switching between the receive channel and the transmit channel.

A baseband signal is transmitted to the transmit channel by a transceiver. The transmit channel amplifies the received radio frequency signal and outputs the radio frequency signal to an antenna. The radio frequency signal is transmitted through the antenna. The power amplifier is responsible for amplifying the radio frequency signal of the transmit channel, and the transmit channel filter is responsible for filtering the radio frequency signal of the transmit channel.

It should be noted that, when the communication device includes a plurality of antennas, one antenna may correspond to one power amplifier, one antenna may correspond to a plurality of power amplifiers, or a plurality of antennas may share one power amplifier. All application scenarios in related technologies are applicable to embodiments of this application.

The receive channel receives the radio frequency signal from the antenna, and the radio frequency signal is amplified by the receive channel and then output, and is transmitted to a baseband by the transceiver. The low noise amplifier is responsible for amplifying the radio frequency signal of the receive channel, and the receive channel filter is responsible for filtering the radio frequency signal of the receive channel. In addition, antenna frequencies applicable to embodiments of this application may include a frequency band with a high bandwidth requirement, for example, a sub-6 GHz frequency band. Certainly, other frequency bands such as a sub-3 GHz frequency band and a Wi-Fi frequency band (for example, a 2.4 GHz frequency band, a 5 GHz frequency band, and a 6 GHz frequency band) are also applicable.

In modern wireless communication systems, modulation signals with high peak-to-average power ratios (peak-to-average power ratios, PAPRs) are usually used to improve utilization of scarce spectrum resources. This signal processing method allows the system to use the spectrum more efficiently, so that a data transmission rate is improved, and an increasing communication requirement is met. The power amplifier is mainly on a downlink in a communication architecture, and is in a direction in which a signal is transmitted from a communication base station to a terminal device. In this process, the signal generated by the base station undergoes a series of processing, including steps such as modulation and frequency mixing, and is finally amplified by the power amplifier. The power amplifier plays an important role in the downlink, and ensures that the communication signal can be effectively transmitted to the terminal device by providing sufficient power, so as to implement a reliable communication connection. However, during actual application, in most service scenarios, service load of the terminal device is not high. As a result, the power amplifier is often in a power back-off state that is far backed off from a signal peak-to-average ratio. In this state, efficiency of the power amplifier is low, resulting in high operating power consumption of an entire circuit. Therefore, optimizing the efficiency and performance of the power amplifier is of great significance to performance and energy efficiency of the entire wireless communication system.

For example, refer to FIG. 2. A dashed curve in FIG. 2 is a theoretical efficiency curve of a conventional class-B power amplifier. It can be learned that, when a power back-off amount of the power amplifier continuously increases, working efficiency of the power amplifier gradually decreases, where the power back-off amount refers to a difference between current power of the power amplifier and maximum power of the power amplifier. Therefore, when the power amplifier is in a power back-off state, the working efficiency of the power amplifier is also low. For a signal with a high peak-to-average power ratio, when a power back-off amount is large, only a small amount of direct current energy of the power amplifier is converted into radio frequency energy, and almost all remaining energy is converted into heat.

In a possible implementation, a Doherty (Doherty, DHT) power amplifier may be used to improve the efficiency of the power amplifier in the power back-off state. The DHT power amplifier may include amplifiers of two different power levels: a main amplifier and an auxiliary amplifier, where the main amplifier processes most power of a system signal, and the auxiliary amplifier processes high peak power. Such division allows the DHT power amplifier to maintain high working efficiency even at a large power back-off amount.

For example, still refer to FIG. 2. A solid curve in FIG. 2 is a theoretical efficiency curve of a two-way symmetric DHT power amplifier. It can be learned that the two-way symmetric DHT power amplifier has two efficiency peak points, which respectively occur at a peak power point and 6 dB back-off from peak power. In comparison with the conventional class-B power amplifier, the two-way symmetric DHT power amplifier has significant efficiency improvement, especially in a high-power output interval (0 to -6 dB). However, when output power of the two-way symmetric DHT power amplifier is at 12 dB back-off from the peak power, the efficiency has dropped from the maximum of 78.5% to around 40%. If the output power continues to decrease to a low-power output interval (-20 dB to -12 dB), the efficiency of the two-way symmetric DHT power amplifier becomes lower.

To improve the efficiency of the DHT power amplifier in the low-power output interval and reduce power consumption of base station equipment, in a possible implementation, a DHT power amplifier including a multi-way structure may be disposed. Because there are a plurality of efficiency peak points, the efficiency of the DHT power amplifier in the low-power output interval can be effectively improved.

As the DHT power amplifier evolves towards the multi-way structure, an area of a circuit of the DHT power amplifier is increased continuously, and a quantity of devices is also increased continuously. Therefore, when high efficiency of the DHT power amplifier is ensured, simplifying the structure of the DHT power amplifier and reducing the quantity of devices are optimization directions for the DHT power amplifier.

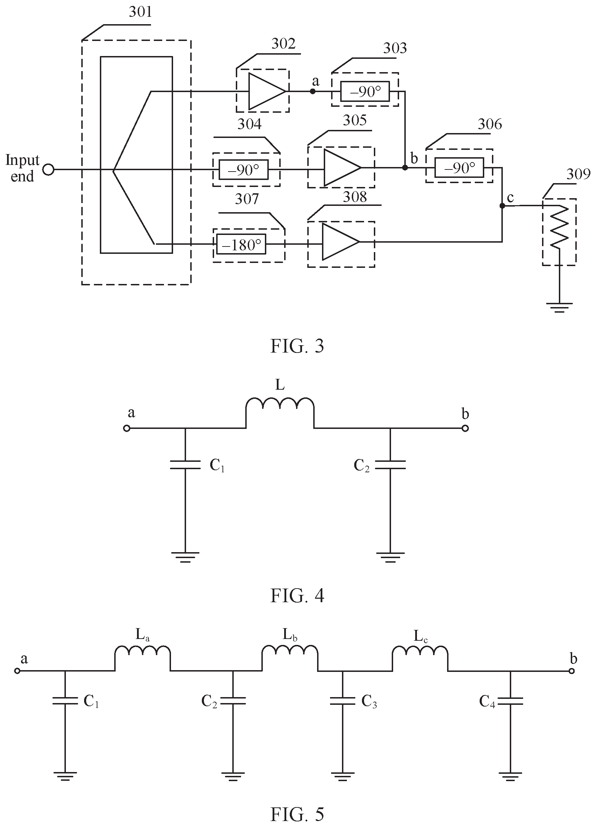

In a possible implementation, an embodiment of this application provides a DHT power amplifier, including a main power amplifier circuit and an auxiliary power amplifier circuit. For example, FIG. 3 is a schematic of a circuit structure of a three-way DHT power amplifier. The three-way DHT power amplifier includes a power splitter 301 disposed at an input end, which is a device that divides energy of one way of input signal into two or more ways with equal or unequal energy for output; or conversely, the three-way DHT power amplifier may combine energy of a plurality of ways of signals into one way for output, and may also be referred to as a combiner in this case. In addition, the three-way DHT power amplifier includes one main power amplifier circuit and two auxiliary power amplifier circuits: a first auxiliary power amplifier circuit and a second auxiliary power amplifier circuit. The main power amplifier circuit includes a carrier amplifier 302 and a first impedance inverter circuit 303. The first auxiliary power amplifier circuit cascaded to the main power amplifier circuit includes a first phase compensation circuit 304, a first peaking amplifier 305, and a second impedance inverter circuit 306. The second auxiliary power amplifier circuit cascaded to the first auxiliary power amplifier circuit includes a second peaking amplifier 308 and a second phase compensation circuit 307, where an output end of the second peaking amplifier 308 is further connected to a load end 309. The carrier amplifier 302 may be biased in class AB or class B, and the first peaking amplifier 305 and the second peaking amplifier 308 may be biased in class C.

To ensure that signals of different ways of the power amplifier are combined in a same phase before entering a load, a phase compensation circuit needs to be added at an input end of a peaking amplifier. To maintain high efficiency at different power output levels of the power amplifier and enable impedance matching between an input port and an output port, an impedance inverter circuit is disposed in the DHT power amplifier. The impedance inverter circuit dynamically changes load impedance of the power amplifier, so that the power amplifier maintains high efficiency at a low power output. At the low power output, usually, only a main power amplifier circuit is in a working state, while an auxiliary power amplifier circuit is in a low power state or in a disconnected state. By using the impedance inverter circuit, load impedance of a main amplifier can be dynamically adjusted based on a requirement of output power, to match an optimal efficiency point of a current working state. Therefore, even at the low power output, the main amplifier can still work with high efficiency, thereby improving efficiency of the entire DHT power amplifier.

Still refer to FIG. 3. The first phase compensation circuit 304, the second phase compensation circuit 307, the first impedance inverter circuit 303, and the second impedance inverter circuit 306 may all be implemented by using conductors. For example, a length of a signal compensation line of the first phase compensation circuit 304 may be λ/4, a length of a signal compensation line of the second phase compensation circuit 307 may be λ/2, and a length of a signal compensation line of each of the first impedance inverter circuit 303 and the second impedance inverter circuit 306 may be λ/4, where λ is a wavelength.

In order to reduce an overall area of the circuit of the DHT power amplifier and save manufacturing costs, an implementation of the impedance inverter circuit may be optimized. In a possible implementation, the impedance inverter circuit may be implemented by using an electronic component. The first impedance inverter circuit 303 and the second impedance inverter circuit 306 may be -90° impedance inverter circuits, which delay a phase of an input signal by 90°. Refer to FIG. 4. The -90° impedance inverter circuit may include a capacitor C₁, a capacitor C₂, and an inductor L. The -90° impedance inverter circuit is a low-pass circuit, and may allow a low-frequency signal to pass through and prevents a high-frequency signal from passing through. The inductor has a specific through-current capability. Therefore, in a high-power scenario, a power requirement of the DHT power amplifier may not be met. However, in a low-power scenario, an existing process condition may not meet a requirement for high inductance.

In a possible implementation, the high inductance may be implemented by using a multi-order impedance inverter circuit. FIG. 5 is a schematic of a third-order implementation of the impedance inverter circuit in FIG. 4, in which an original first-order structure is decomposed into a third-order structure, where the capacitor C₁, the capacitor C₂, and an inductor Lₐ are of a first-order structure, the capacitor C₂, a capacitor C₃, and an inductor L_{b} are of a second-order structure, and the capacitor C₃, a capacitor C₄, and an inductor L_{c} are of a third-order structure.

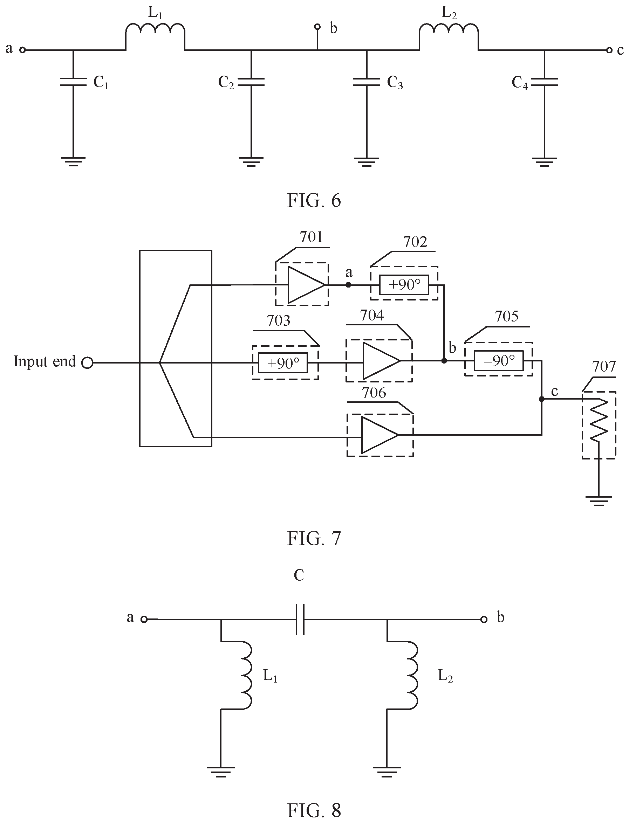

FIG. 6 is a schematic of a circuit topology structure of the first impedance inverter circuit 303 and the second impedance inverter circuit 306 in FIG. 3. It can be learned that an inductor L₁ is connected in series between an output end (a) of the carrier amplifier and an output end (b) of the first peaking amplifier, and an inductor L₂ is connected in series between the output end (b) of the first peaking amplifier and an output end (c) of the second peaking amplifier. That is, a device between any power amplifiers is an inductor. Because the inductor does not have a characteristic of direct current blocking, voltages of power amplifiers at two ends of the inductor are the same. As a result, different drain voltage supply cannot be applied to the main power amplifier circuit and the auxiliary power amplifier circuit. In addition, as the DHT power amplifier evolves towards a multi-way structure, each time one way is added, an impedance inverter circuit and a phase compensation circuit are added to the way.

A power amplifier provided in this application is described with reference to FIG. 7. The power amplifier may include a carrier amplifier 701, a first peaking amplifier 704, and a second peaking amplifier 706. A first impedance inverter circuit 702 is disposed between an output end (a) of the carrier amplifier 701 and an output end (b) of the first peaking amplifier 704, and a second impedance inverter circuit 705 is disposed between the output end (b) of the first peaking amplifier 704 and an output end (c) of the second peaking amplifier 706. The first impedance inverter circuit 702 and the second impedance inverter circuit 705 have opposite phases and a same phase compensation angle. For example, the first impedance inverter circuit 702 may be a +90° impedance inverter circuit, and the second impedance inverter circuit 705 may be a -90° impedance inverter circuit.

The first impedance inverter circuit 702 and the second impedance inverter circuit 705 may form a left/right-handed topology combiner, where the left/right-handed topology combiner may be a three-port combiner, in which three ports of the three-port combiner may be respectively a port a connected to the carrier amplifier, a port b connected to the output end of the first peaking amplifier 704, and a port c connected to the output end of the second peaking amplifier 706.

In comparison with the three-way DHT power amplifier in FIG. 3, the impedance inverter circuit of the power amplifier in this embodiment is optimized, so that a phase compensation circuit of the entire power amplifier is simplified. To be specific, no phase compensation circuit needs to be added to an input end of the second peaking amplifier 706, which is equivalent to deleting two 90° phase compensation circuits. Therefore, an area of the entire circuit is significantly reduced. By optimizing the impedance inverter circuit, the phase compensation circuit is further simplified, so that for the power amplifier in this embodiment, the circuit area of the entire power amplifier can be reduced under the premise of ensuring performance, thereby reducing production costs and circuit complexity. In addition, because a quantity of devices in the power amplifier is reduced, reliability and stability of the entire power amplifier are improved. It should be noted that a structure of the power amplifier shown in FIG. 7 is not only applicable to the three-way DHT power amplifier, but also applicable to a first three-way structure of a multi-way DHT power amplifier.

To ensure the stability of the power amplifier, phases of signals at a combination point need to be consistent. In a possible implementation, the power amplifier further includes a phase compensation circuit, where the phase compensation circuit is connected to an input end of the first peaking amplifier, and the phase compensation circuit and the second impedance inverter circuit have opposite phases and a same phase compensation angle.

Still refer to FIG. 7. A first phase compensation circuit 703 is further disposed between a power splitter and the first peaking amplifier 704, and the first phase compensation circuit 703 and the second impedance inverter circuit 705 have opposite phases and a same phase compensation angle. For example, the first phase compensation circuit 703 may be a +90° impedance inverter circuit, and the second impedance inverter circuit 705 is a -90° impedance inverter circuit.

In the power amplifier shown in FIG. 7, an input signal is divided into three ways of signals by the power splitter. A 1^{st} way of signal is amplified by the carrier amplifier 701, and then passes through the +90° impedance inverter circuit for output. A 2^{nd} way of signal passes through the +90° phase compensation circuit, and then is amplified by the first peaking amplifier 704. The two ways of signals are output and combined at the first peaking amplifier 704, and then pass through the -90° impedance inverter circuit. A 3^{rd} way of signal is amplified by the second peaking amplifier 706 and then combined with the first two ways of signals at an output point, before entering a load end 707.

To improve broadband linearity of the power amplifier, in a possible implementation, the first impedance inverter circuit is a high-pass circuit, and the second impedance inverter circuit is a low-pass circuit.

The high-pass circuit is a circuit that allows a high-frequency signal to pass through and suppresses a low-frequency signal. This characteristic enables the high-pass circuit to have a good suppression effect when processing a low-frequency voltage broadband signal, thereby improving the broadband linearity of the entire power amplifier. The broadband linearity means that when processing a broadband signal, the power amplifier can maintain an original characteristic of the signal and avoid signal distortion. In a wireless communication system, signal transmission is usually subject to various forms of interference, such as noise and attenuation. These factors deteriorate signal quality and affect the communication effect. Setting the first impedance inverter circuit to a high-pass circuit can effectively reduce such interference, enabling the signal to maintain a purer state in the transmission process.

In a possible implementation, a specific circuit structure of the high-pass circuit may be shown in FIG. 8, including: a first inductor (L₁), a second inductor (L₂), and a first capacitor (C). A first end of the first inductor (L₁) and a first end of the first capacitor (C) are connected to an input end (a) of the high-pass circuit, a first end of the second inductor (L₂) and a second end of the first capacitor (C) are connected to an output end (b) of the high-pass circuit, and a second end of the first inductor (L₁) and a second end of the second inductor (L₂) are connected to a ground end.

A specific circuit structure of the low-pass circuit may be shown in FIG. 4, including: a second capacitor (C₁), a third capacitor (C₂), and a third inductor (L). A first end of the second capacitor (C₁) and a first end of the third inductor (L) are connected to an input end of the low-pass circuit, a first end of the third capacitor (C₂) and a second end of the third inductor (L) are connected to an output end of the low-pass circuit, and a second end of the second capacitor (C₁) and a second end of the third capacitor (C₂) are connected to a ground end.

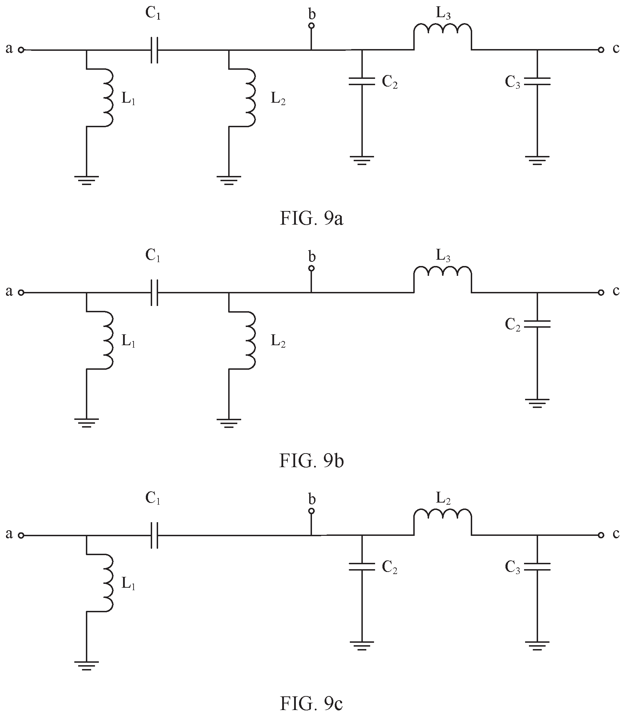

FIG. 9a to FIG. 9c are schematics of circuit topology structures of the first impedance inverter circuit 702 and the second impedance inverter circuit 705 in FIG. 7. Refer to FIG. 9a, a capacitor C₁ is connected in series between the output end (a) of the carrier amplifier and the output end (b) of the first peaking amplifier, and an inductor L₃ is connected in series between the output end (b) of the first peaking amplifier and the output end (c) of the second peaking amplifier. Because the capacitor has a characteristic of direct current blocking, voltages of power amplifiers at two ends of the capacitor C may be different. In other words, different drain voltage supply can be applied to the output end (a) of the carrier amplifier and the output end (b) of the first peaking amplifier. In addition, the peaking amplifier allows higher drain voltage supply, and may provide higher output power during a signal peak period. Therefore, a better broadband characteristic may be obtained when a high-frequency signal is processed. During actual application, because the inductor L₂ and the capacitor C₂ in FIG. 9a are resonant, two cases may occur. Refer to FIG. 9b, in a first case, only the original inductor L₂ remains, and other capacitors and inductors remain unchanged. Refer to FIG. 9c, in a second case, only the original capacitor C₂ remains, and other capacitors and inductors remain unchanged.

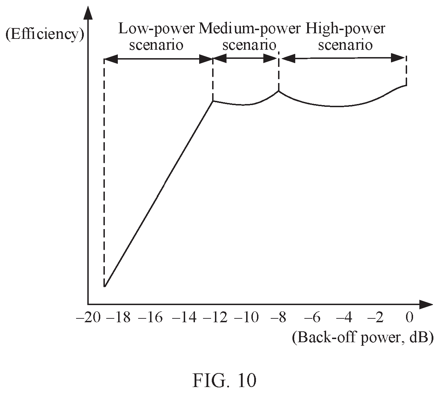

With reference to FIG. 10, the following describes working processes, in different working scenarios, of the DHT power amplifier provided in embodiments of this application. Refer to FIG. 10. In a low-power scenario, an input signal is small, only a carrier amplifier works in a high-efficiency state while other power amplifiers are not turned on. Output power is backed off by more than 12 dB compared with full power. In a medium-power scenario, input power increases continuously, and a first peaking amplifier is turned on, and works with a carrier amplifier in a Doherty mode until the two power amplifiers reach maximum power at the same time. In this case, output power of the power amplifier is backed off by more than 9 dB compared with the full power. In a high-power scenario, input power is further increased, and a second peaking amplifier is turned on, and forms a three-way DHT structure with a carrier amplifier and a first peaking amplifier respectively until both the carrier amplifier and the two peaking amplifiers reach maximum power for output. In this case, output power of the power amplifier reaches maximum power, and high efficiency is maintained.

For a structure of another way in a multi-way DHT power amplifier, there may be a plurality of implementations. In a possible implementation, the multi-way DHT power amplifier may include one or more third peaking amplifiers. For example, when the DHT power amplifier includes N third peaking amplifiers, a third impedance inverter circuit numbered 1 is disposed between a third peaking amplifier numbered 1 and a second peaking amplifier, and a third impedance inverter circuit numbered N is disposed between a third peaking amplifier numbered N-1 and a third peaking amplifier numbered N. When there are a plurality of third impedance inverter circuits, any third impedance inverter circuit may be a high-pass circuit or a low-pass circuit.

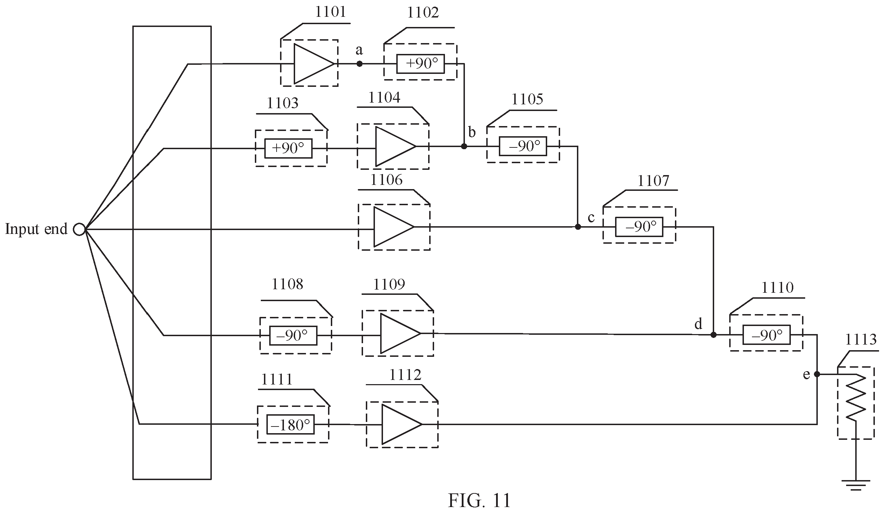

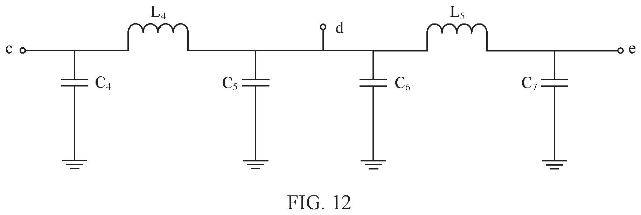

For example, refer to FIG. 11. A five-way DHT power amplifier is used for description. The five-way DHT power amplifier includes a carrier amplifier 1101, a first peaking amplifier 1104, a second peaking amplifier 1106, and two adjacent third peaking amplifiers, to be specific, a third peaking amplifier 1109 and a third peaking amplifier 1112. A first impedance inverter circuit 1102 is disposed between an output end (a) of the carrier amplifier 1101 and an output end (b) of the first peaking amplifier 1104, and a second impedance inverter circuit 1105 is disposed between the output end (b) of the first peaking amplifier 1104 and an output end (c) of the second peaking amplifier 1106. A phase compensation circuit 1103 is disposed at an input end of the second peaking amplifier 1106, a third impedance inverter circuit 1107 is disposed between an output end (d) of the third peaking amplifier 1109 and the output end (c) of the second peaking amplifier 1106, a third impedance inverter circuit 1110 is also disposed between the output end (d) of the third peaking amplifier 1109 and an output end (e) of the third peaking amplifier 1112, a phase compensation circuit 1108 is disposed at an input end of the third peaking amplifier 1109, a phase compensation circuit 1111 is disposed at an input end of the third peaking amplifier 1112, and the output end (e) of the third peaking amplifier 1112 is further connected to a load end 1113. The third impedance inverter circuit 1107 and the third impedance inverter circuit 1110 that are cascaded have a same phase and a same phase compensation angle. For example, the third impedance inverter circuit 1107 may be a -90° impedance inverter circuit, and the third impedance inverter circuit 1110 may be a -90° impedance inverter circuit. FIG. 12 is a schematic of a circuit topology structure of the third impedance inverter circuit 1107 and the third impedance inverter circuit 1110 in FIG. 11. Refer to FIG. 12. An inductor L₄ is connected in series between the output end (c) of the second peaking amplifier 1106 and the output end (d) of the third peaking amplifier 1109, and an inductor L₅ is connected in series between the output end (d) of the third peaking amplifier 1109 and the output end (e) of the third peaking amplifier 1112. That is, devices connected to the third peaking amplifiers are all inductors.

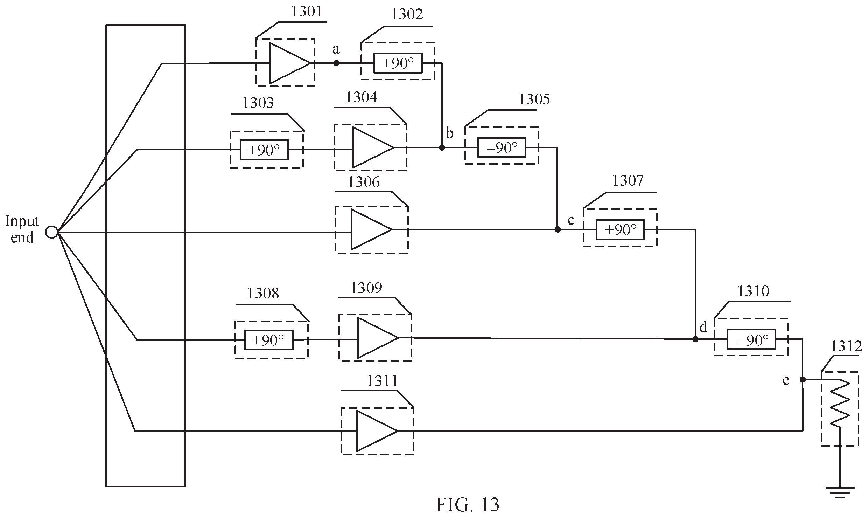

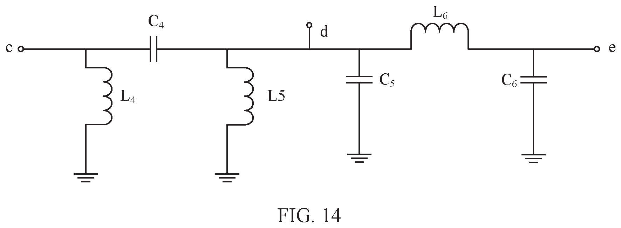

Refer to FIG. 13. A power amplifier includes a carrier amplifier 1301, a first peaking amplifier 1304, a second peaking amplifier 1306, and two adjacent third peaking amplifiers, to be specific, a third peaking amplifier 1309 and a third peaking amplifier 1311. A first impedance inverter circuit 1302 is disposed between an output end (a) of the carrier amplifier 1301 and an output end (b) of the first peaking amplifier 1304, and a second impedance inverter circuit 1305 is disposed between the output end (b) of the first peaking amplifier 1304 and an output end (c) of the second peaking amplifier 1306. A phase compensation circuit 1303 is disposed at an input end of the second peaking amplifier 1306, a third impedance inverter circuit 1307 is disposed between an output end (d) of the third peaking amplifier 1309 and the output end (c) of the second peaking amplifier 1306, a third impedance inverter circuit 1310 is also disposed between the output end (d) of the third peaking amplifier 1309 and an output end (e) of the third peaking amplifier 1311, a phase compensation circuit 1308 is disposed at an input end of the third peaking amplifier 1309, and no phase compensation circuit is disposed at an input end of the third peaking amplifier 1311. The third impedance inverter circuit 1307 and the third impedance inverter circuit 1310 that are cascaded have opposite phases and a same phase compensation angle. For example, the third impedance inverter circuit 1307 may be a +90° impedance inverter circuit, the third impedance inverter circuit 1310 may be a -90° impedance inverter circuit, and the output end (e) of the third peaking amplifier 1311 is further connected to a load end 1312. FIG. 14 is a schematic of a circuit topology structure of the third impedance inverter circuit 1307 and the third impedance inverter circuit 1310 in FIG. 13. Refer to FIG. 14. A capacitor C₄ is connected in series between the output end (c) of the second peaking amplifier 1306 and the output end (d) of the third peaking amplifier 1309, and an inductor L₆ is connected in series between the output end (d) of the third peaking amplifier 1309 and the output end (e) of the third peaking amplifier 1311. That is, the inductor and the capacitor alternately appear as a device connected between the third peaking amplifiers.

It can be learned that, when the inductor and the capacitor alternately appear as the device connected between the third peaking amplifiers, in comparison with a case in which the devices connected between the third peaking amplifiers are all inductors, one phase compensation circuit may be saved for every two ways on which there are third peaking amplifiers.

This application further provides a radio frequency chip, including a substrate and a power amplifier, where the power amplifier is disposed on the substrate, and the power amplifier is the power amplifier provided in the foregoing embodiments.

In several embodiments provided in this application, it should be understood that control and a memory of the provided electronic device may be implemented in other manners. For example, division into a module is merely logical function division. During actual implementation, there may be another division manner. For example, a plurality of units or components may be combined or integrated into another system, or some features may be ignored or not performed.

It should be noted herein that the foregoing is merely described by using an example in which a part of devices in the power amplifier circuit are located in the power amplifier chip and a part of devices are located on the substrate. Certainly, all of devices in the power amplifier circuit provided in embodiments of this application may alternatively be disposed in the power amplifier chip. In addition, a part of devices may be located in the power amplifier chip, and a part of devices may be located on the substrate, but components located in the power amplifier chip are different from those shown in the foregoing embodiments. A layout of devices in the power amplifier circuit is not limited in embodiments of this application. The examples in embodiments are merely an example.

The foregoing descriptions are merely specific implementations of this application. However, the protection scope of this application is not limited thereto. Any change or replacement readily figured out by a person skilled in the art within the technical scope disclosed in this application shall fall within the protection scope of this application. Therefore, the protection scope of this application shall be subject to the protection scope of the claims.

## Claims

1. A power amplifier, comprising: a carrier amplifier, a first peaking amplifier, and a second peaking amplifier, wherein
a first impedance inverter circuit is disposed between an output end of the carrier amplifier and an output end of the first peaking amplifier;
a second impedance inverter circuit is disposed between the output end of the first peaking amplifier and an output end of the second peaking amplifier; and
the first impedance inverter circuit and the second impedance inverter circuit have opposite phases and a same phase compensation angle.

2. The power amplifier according to claim 1, wherein the power amplifier further comprises a phase compensation circuit, the phase compensation circuit is connected to an input end of the first peaking amplifier, and the phase compensation circuit and the second impedance inverter circuit have opposite phases and a same phase compensation angle.

3. The power amplifier according to claim 2, wherein the power amplifier further comprises a third peaking amplifier, and a third impedance inverter circuit is disposed between an output end of the third peaking amplifier and the output end of the second peaking amplifier.

4. The power amplifier according to claim 2, wherein the power amplifier further comprises a plurality of third peaking amplifiers, a third impedance inverter circuit is disposed between an output end of one of the third peaking amplifiers and the output end of the second peaking amplifier, and the third impedance inverter circuit is disposed between output ends of any two cascaded third peaking amplifiers.

5. The power amplifier according to claim 4, wherein any two adjacent third impedance inverter circuits have a same phase and a same phase compensation angle.

6. The power amplifier according to claim 4, wherein at least two adjacent third impedance inverter circuits have opposite phases and a same phase compensation angle.

7. The power amplifier according to claim 1, wherein the first impedance inverter circuit is a high-pass circuit, and the second impedance inverter circuit is a low-pass circuit.

8. The power amplifier according to claim 7, wherein the high-pass circuit comprises: a first inductor, a second inductor, and a first capacitor, wherein
a first end of the first inductor and a first end of the first capacitor are connected to an input end of the high-pass circuit, a first end of the second inductor and a second end of the first capacitor are connected to an output end of the high-pass circuit, and a second end of the first inductor and a second end of the second inductor are connected to a ground end.

9. The power amplifier according to claim 7, wherein the low-pass circuit comprises: a second capacitor, a third capacitor, and a third inductor, wherein
a first end of the second capacitor and a first end of the third inductor are connected to an input end of the low-pass circuit, a first end of the third capacitor and a second end of the third inductor are connected to an output end of the low-pass circuit, and a second end of the second capacitor and a second end of the third capacitor are connected to a ground end.

10. A radio frequency chip, comprising: a substrate and a power amplifier, wherein the power amplifier is disposed on the substrate, and the power amplifier is the power amplifier according to any one of claims 1 to 9.

11. A base station, comprising: a baseband processing circuit and a radio frequency front-end circuit, wherein the baseband processing circuit is connected to the radio frequency front-end circuit, the radio frequency front-end circuit comprises a power amplifier, and the power amplifier is the power amplifier according to any one of claims 1 to 9.
